Europäisches Patentamt

European Patent Office

Office européen des brevets

(11) Publication number: **0 426 609 A2**

# EUROPEAN PATENT APPLICATION

(21) Application number: **90730013.1**

(51) Int. Cl.⁵: **H01L 21/48**

(22) Date of filing: **27.10.90**

(30) Priority: **01.11.89 JP 285604/89**

(43) Date of publication of application:
**08.05.91 Bulletin 91/19**

(84) Designated Contracting States:
**DE FR GB**

(71) Applicant: **MITSUBISHI MINING & CEMENT CO., LTD.**
**23-go, 6-ban, Takanowa 4-chome**
**Minato-ku, Tokyo(JP)**

(72) Inventor: **Hirai, Michio**
**2270-banchi Ooaza Yokose, Yokose-cho**
**Chichibu-gun, Saitama-ken(JP)**

(74) Representative: **Goddar, Heinz J., Dr. et al**
**FORRESTER & BOEHMERT**
**Widenmayerstrasse 4/I**
**W-8000 München 22(DE)**

(54) Ceramic insulating substrate and process for producing the same.

(57) A ceramic insulating substrate which is disclosed herein comprises a thin ceramic substrate material made by a sol-gel process, and a thick film formed and deposited on each of surfaces of the ceramic substrate material by baking a thick film paste printed in a pad pattern. The ceramic insulating substrate is produced by providing a thin ceramic substrate material made by a sol-gel process, printing a thick film paste onto each of surfaces of the substrate material in a pad pattern, and baking the thick film paste in the pad pattern to form a thick film on each of the surfaces of the substrate material.

EP 0 426 609 A2

# CERAMIC INSULATING SUBSTRATE AND PROCESS FOR PRODUCING THE SAME

The present invention relates to a ceramic insulating substrate for use in mounting a transistor and a semi-conductor integrated circuit thereon and a process for producing the same, and more particularly, to a ceramic insulating substrate excellent in insulating and heat dissipating properties and suitable for reduction in weight and size and a process for producing the same wherein a baking at a lower temperature for a shorter period of time is enough, and such baking can be conducted even in the atmospheric air or in a nitrogen gas atmosphere.

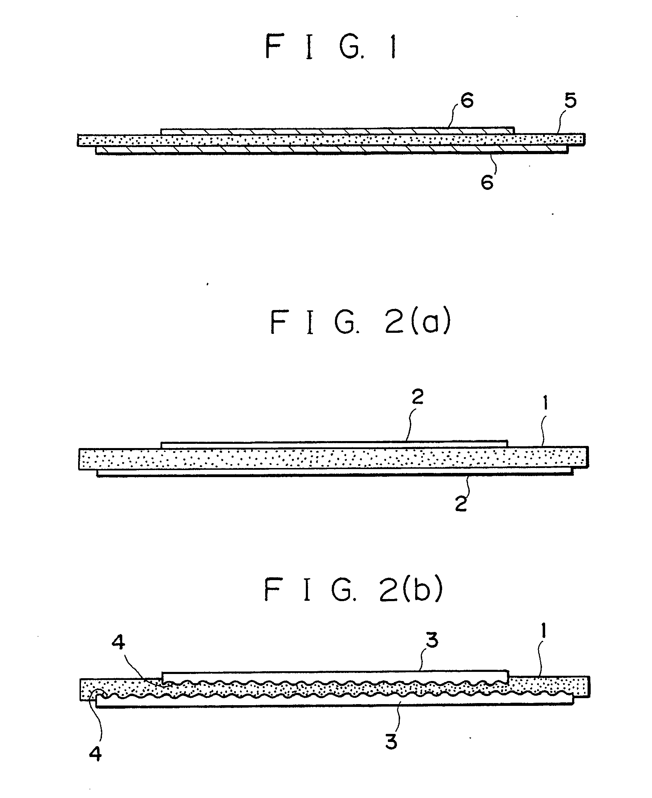

Such a ceramic insulating substrate is conventionally produced in a process which comprises printing a thick film paste 2 including a metal having a higher melting point such as Mo and W onto opposite surfaces of an alumina substrate material 1 having a thickness of 0.4 m or more, for example, as shown in Fig. 2(a), thereby forming a pattern for connecting a chip such as a transistor and a heat dissipating plate, and then subjecting the alumina substrate material 1 having the thick film paste 2 deposited thereon at a predetermined location to a thermal treatment (i.e., baking treatment) at a high temperature such as 1,500°C for a long period of time in a reducing gas atmosphere such as hydrogen gas. Thus, a thick film 3 including the metal having a higher melting point is formed on each of the surfaces of the alumina substrate material, with the metal 4 having a higher melting point being diffused into the alumina material with a shorter heat insulating distance of the alumina material at such diffused portion, as shown in Fig.2(b).

However, when a heat dissipating property is to be provided to the alumina insulating substrate material by diffusing a metal having a higher melting point into the alumina material as described above, the heat dissipation of the alumina substrate material may be basically hindered, and it is difficult to reduce the size and weight of an electronic device incorporating such substrate material, because the prior art alumina substrate material is thick. In addition, because a metal having a higher melting point is employed for formation of a thick film and for diffusion of the metal, the baking temperature must be increased and the baking time must be prolonged. This is accompanied by the problem that the metal having a higher melting point is liable to be oxidized and volatilized off in the form of an oxide. Therefore, it is necessary to conduct the baking in a reducing gas atmosphere such as hydrogen gas. A further problem is that because a metal having a higher melting point such as Mo and W is inferior in bonding property of a solder, a plating of a higher electric conductivity such as Ni or Au plating must be applied onto a thick film including such a metal having a higher melting point.

The present inventors have made repeated studies with the above problems in view and consequently have found the following aspects:

(1) If a ceramic substrate material having a thickness smaller than that of the prior art ceramic substrate material, e.g., of less than 0.4 mm, such as an alumina substrate material, is used in producing a ceramic insulating substrate, and when various electronic devices are assembled from such ceramic insulating substrate, it is possible to provide a reduction in size and weight of such devices, because the alumina substrate material is thinner but still excellent in insulating property.

(2) If the alumina substrate material is thinner as described above, the heat insulating distance thereof is originally small. Therefore, even if the heat insulating distance of the alumina substrate material is not reduced by utilizing a diffusing phenomenon of a metal having a higher melting point as in the prior art, the alumina substrate material itself will exhibit an excellent heat dissipating property over the prior art substrate material.

(3) Because it is unnecessary to form a diffused layer of a metal having a higher melting point in the alumina material as described above, a pad pattern made of a thick film paste of a metal having relatively low melting point and a rich electric conductivity such as Cu, Ni, AgPd and the like may be printed on the alumina substrate material and baked, thereby forming only a thick film. This ensures that the baking can be achieved even at a lower temperature such as 850°C and further even in an atmosphere other than a reducing gas atmosphere, such as in the atmospheric air or in a nitrogen atmosphere, and any time-consuming diffusing treatment of a metal having a higher melting point is unnecessary, leading to a reduction in entire time required for the baking. Further, the electric conductivity of the entire thick film may be improved and hence, a plating such as a gold plating need not to be applied to the alumina substrate material.

Accordingly, it is an object of the present invention to provide a ceramic insulating substrate excellent in insulating and heat dissipating properties and suitable for reduction in weight and size.

It is another object of the present invention to provide a process for producing a ceramic insulating substrate of the type described above, wherein a thermal treatment at a lower temperature for a shorter period of time is enough, and such baking can be conducted even in the atmospheric air or in an atmosphere of a gas other than a reducing gas, such as in a nitrogen gas atmosphere.

To achieve the above first object, according to the present invention, there is provided a ceramic insulating substrate comprising a thin ceramic substrate material made by a sol-gel process, and a thick film formed and deposited on each of the surfaces of the ceramic substrate material by baking a thick film paste printed in a pad pattern.

In addition, there is provided a ceramic insulating substrate comprising a thin ceramic substrate material made by a sol-gel process and coated with a thin film of a electric conductive metal on each of its opposite surfaces, and a thick film formed and deposited on each of the surfaces of the ceramic substrate material by baking a thick film paste printed in a pad pattern.

To achieve the above second object, according to the present invention, there is provided a process for producing a ceramic insulating substrate having a thick film, comprising the steps of:

(a) providing a thin ceramic substrate material made by a sol-gel process;

(b) printing a thick film paste onto each of surfaces of the substrate material in a pad pattern; and

(c) baking the thick film paste in the pad pattern to form a thick film on each of the surfaces of the substrate material.

In addition, there is provided a process for producing a ceramic insulating substrate having a thick film, comprising the steps of:

(a) providing a thin ceramic substrate material made by a sol-gel process and coated with a thin film of a electric conductive metal on each of its opposite surfaces;

(b) printing a thick film paste onto each of surfaces of the substrate material in a pad pattern; and

(c) baking the thick film paste in the pad pattern to form a thick film on each of the surfaces of the substrate material.

The ceramic insulating substrate according to the present invention has excellent insulating and heat dissipating properties and is suitable for reduction in weight and size. In addition, in the process for producing a ceramic insulating substrate of the type described above according to the present invention, the baking at a lower temperature and for a shorter period of time is enough and can be carried out even in an atmosphere other than a reducing gas atmosphere such as in the atmospheric air or in a nitrogen gas.

Fig. 1 is a sectional view of a typical ceramic insulating substrate according to the present invention; and

Fig. 2 is a sectional view for explaining steps of producing a prior art alumina substrate, Fig. 2(a) illustrating a state in the middle of production, and Fig.2(b) illustrating a finished state.

The present invention will now be described in more detail.

(1) Thin Ceramic Substrate Material

As used herein, the word "a thin ceramic substrate material" means a ceramic substrate material made by a sol-gel process and having a thickness of less than 0.4 mm. The thickness of the ceramic substrate material is preferably of 0.03 to 0.2 mm, more preferably 0.1 to 0.2 mm. Among such substrate materials, a alumina substrate material having a specific gravity of 3.7 to 3.9 is preferred.

In such a thin ceramic substrate material made by a sol-gel process and having a thickness of less than 0.4 mm, e.g., an alumina aubstrate material has the following properties: a density of 3.75 $g/cm^3$ or more, a porosity of 0%, and a dielectric strength of 30 kV/mm, and itself has a higher insulating property. Therefore, the substrate material made of such an alumina exhibits an excellent insulating property over the prior art alumina substrate material made by a powder process.

(2) Thick Film Paste

Examples of the thick film paste printed in the pad pattern on the substrate material which may be used herein are pastes used in the conventional thick film technology, e.g., those formed by mixing a metal powder such as Cu, Ni, AgPd, Ag, Au, Pt, Pd, Rh and Ru and a glass powder, and adding an organic resin and an organic solvent to such mixture and kneading together. Such a thick paste may be printed on the substrate material by a printing process such as a screen printing process or a transfer printing process to form a predetermined pad pattern.

(3) Baking Treatment

If the paste printed in the above-described manner is baked in a suitable atmosphere, e.g., in a nitrogen gas atmosphere or in a reducing gas atmosphere, generally at a temperature of 600 to 900°C for 30 to 60 minutes, such paste is converted into a thick film with particles of metal and metal oxide covered with glass and bonded together. This thick film serves as a pad for bonding an electric heating element or a heat dissipating structure such as a transistor and a semiconductor integrated circuit.

The ceramic insulating substrate of the present invention made in the above manner may be used as an insulating substrate when a power transistor, LSI and the like are mounted thereon, and particularly, such ceramic insulating substrate may be conveniently used as an insulating substrate which exhibits an excellent heat dissipating property when an electric element attendant with heat evolution such as a large-current circuit is mounted thereon.

[Examples]

The present invention will now be described by way of Examples, but is, of course, not intended to be limited to these Examples.

Example 1

First, an alumina substrate material 5 made by a sol-gel process and having a thickness of 0.2 mm as shown in Fig. 1 was provided. Then, pads for connecting a transistor and a heat dissipating plate were printed onto opposite surfaces of the substrate material, respectively, with a Cu paste containing a fine powder of Cu, a glass powder, an organic solvent and an organic binder by a screen printing process.

Then, the printed paste was baked under a condition where it was maintained at a temperature of 850°C for 45 minutes in a nitrogen gas atmosphere containing a very small amount (10 ppm or less) of oxygen. Thereafter, Ni and Au plating films were sequentially applied to a surface of the formed Cu printed portion, thereby producing an insulating substrate of the present invention, which had thick films 6 for connecting a transistor and a heat dissipating plate, on opposite surfaces of the alumina substrate material 5, respectively.

It should be noted that the above-described plating films can be omitted.

Subsequently, an insulating substrate for comparison was produced in a similar procedure, except that the above described alumina substrate material was replaced by an alumina substrate material made by the conventional powder process and having a thickness of 0.4 mm; the above described paste of Cu was replaced by a paste of Mo formed by adding an organic resin and an organic solvent to a mixture of Mo powder, a glass powder and the like and kneading them together; the baking time was of 4 hours; and the baking atmosphere was a hydrogen gas atmosphere.

The insulating substrates produced in the above manner were examined for their insulating properties and thermal resistances to provide the following results:

|  | Insulating property (dielectric strength) | Thermal resistance |
|---|---|---|
| Substrate of the Invention | 30 kV/mm | 0.07 cal/cm sec °C |
| Substrate for Comparison | 14 kV/mm | 0.06 cal/cm sec °C |

Example 2

An insulating substrate of the present invention and an insulating substrate for comparison were produced in a procedure similar to that in Example 1, except that starting substrate materials made by previously coating NiCr and Cu in sequence onto the above-described two alumina substrate materials by spattering were used.

4

|  | Insulating property (dielectric strength) | Thermal resistance |
|---|---|---|
| Substrate of the Invention | 30 kV/mm | 0.07 cal/cm sec °C |
| Substrate for Comparison | 14 kV/mm | 0.06 cal/cm sec °C |

From the results obtained in the above Examples, it can be seen that the insulating substrates of the present invention have more excellent insulating and heat dissipating properties than those of the insulating substrates for comparison.

## Claims

1. A ceramic insulating substrate comprising a thin ceramic substrate material (5) made by a sol-gel process, and a thick film (6) formed and deposited on each of the surfaces of said ceramic substrate material (5) by baking a thick film paste printed in a pad pattern.

2. A ceramic insulating substrate comprising a thin ceramic substrate material (5) made by a sol-gel process and coated with a thin film of a electric conductive metal on each of its opposite surfaces, and a thick film (6) formed and deposited on each of the surfaces of said ceramic substrate material (5) by baking a thick film paste printed in a pad pattern.

3. A process for producing a ceramic insulating substrate having a thick film (6), comprising the steps of:
   (a) providing a thin ceramic substrate material (5) made by a sol-gel process;
   (b) printing a thick film paste onto each of surfaces of said substrate material (5) in a pad pattern; and
   (c) baking said thick film paste in the pad pattern to form a thick film (6) on each of the surfaces of said substrate material (5).

4. A process for producing a ceramic insulating substrate having a thick film (6), comprising the steps of:
   (a) providing a thin ceramic substrate material (5) made by a sol-gel process and coated with a thin film of an electric conductive metal on each of its opposite surfaces;
   (b) printing a thick film paste onto each of the surfaces said substrate material (5) in a pad pattern; and
   (c) baking said thick film paste in the pad pattern to form a thick film (6) on each of the surfaces of said substrate material.

# F I G. 1

# F I G. 2(a)

# F I G. 2(b)